# EUROPEAN PATENT APPLICATION

(11) **EP 4 844 424 A1**
(43) Date of publication of application: **25.11.2026**
(21) Application number: 25863875.8
(22) Date of filing: 28.07.2025
(51) Int. Cl.: G01R 31/3177, G01R 31/3183, G01R 31/317, G01R 31/40, H02M 11/00

(54) **METHOD FOR DIAGNOSING TARGET DEVICE AND ELECTRONIC DEVICE FOR PERFORMING SAME**

(30) Priority: 04.09.2024 KR 20240119947
(71) Applicant: LG Energy Solution, Ltd., Seoul 07335 (KR)
(72) Inventor: RYU, Jeong Hun, Daejeon 34122 (KR); JEONG, Dooho, Daejeon 34122 (KR)
(74) Representative: Plasseraud IP
(86) International application number: PCT/KR2025/011155
(87) International publication number: WO 2026/054325

(57) **Abstract**

Disclosed are an electronic device and a device diagnosis method, the electronic device comprising: a diagnosis result output circuit including a plurality of diagnosis circuits and a logic gate connected to output terminals of the plurality of diagnosis circuits; a memory storing instructions; and a processor connected to the memory, wherein the processor is configured to: apply a voltage to one ends of a plurality of diagnosis target devices included in the plurality of diagnosis circuits; and diagnose whether the plurality of diagnosis target devices operate normally on the basis of an output value of the diagnosis result output circuit, the output value generated by the logic gate on the basis of values received from the output terminals of the plurality of diagnosis circuits to which the voltage has been applied.

## Description

### Technical Field

The present disclosure relates to a method for diagnosing a target element and an electronic device for performing the same.

### Background Art

A power conversion device performs conversion between a direct current voltage and an alternating current voltage, or between a high voltage and a low voltage to supply electric power suitable for various situations. When a fault occurs in a connection relationship of an internal circuit of the device during the driving of the power conversion device, there is a risk that the device may be damaged or a fire may occur due to overcurrent. Accordingly, various studies have been conducted on methods for determining whether internal elements of the power conversion device are properly connected and driven and for enhancing the stability and efficiency of the power conversion device.

### Detailed Description of the Invention

### Technical Goals

Through a method for diagnosing a target element and an electronic device for performing the same, the disclosed example embodiments are to provide a method for diagnosing whether a target element normally operates based on a value generated through a logic gate based on an output value of a diagnostic circuit by applying a voltage to an end of the diagnostic circuit to which the target element whose normal operation is to be determined is connected.

A technical task to be achieved by an example embodiment of the present disclosure is not limited to the technical task described above, and other technical tasks may be derived from example embodiments described below.

### Technical solutions

An electronic device according to an example embodiment may include a diagnostic result output circuit including a plurality of diagnostic circuits and a logic gate that is connected to output ends of the plurality of diagnostic circuits, a memory storing an instruction, and a processor connected to the memory. The processor may be configured to apply a voltage to an end of each of a plurality of target elements to be diagnosed included in the plurality of diagnostic circuits and diagnose whether the plurality of target elements to be diagnosed normally operate based on an output value of the diagnostic result output circuit generated by the logic gate based on values received from the output ends of the plurality of diagnostic circuits to which the voltage is applied.

The processor may be configured to determine, when a first value is received through an output end of the diagnostic result output circuit, that the plurality of target elements to be diagnosed normally operate and determine, when a second value is received through the output end of the diagnostic result output circuit, that at least one of the plurality of target elements to be diagnosed abnormally operates.

The plurality of diagnostic circuits may include a first diagnostic circuit. The first diagnostic circuit may include a first resistor connected to a first end of a first target element to be diagnosed, a second resistor connected to a second end of the first target element to be diagnosed, a third resistor connected to the first resistor, a fourth resistor connected to the second resistor, and a first comparator including a first input terminal connected to the third resistor, a second input terminal connected to the fourth resistor, and an output terminal.

A ratio of the third resistor to a sum of the first resistor and the third resistor may be greater than a ratio of the fourth resistor to a sum of the second resistor and the fourth resistor.

The first comparator may output, when a voltage applied to the first input terminal is greater than a voltage applied to the second input terminal, a first value to the logic gate through the output terminal and output, when the voltage applied to the first input terminal is less than the voltage applied to the second input terminal, a second value to the logic gate through the output terminal.

The plurality of diagnostic circuits may include a second diagnostic circuit. The second diagnostic circuit may include a fifth resistor connected to a first end of a second target element to be diagnosed, a sixth resistor connected to a second end of the second target element to be diagnosed, a seventh resistor connected to the fifth resistor, an eighth resistor connected to the sixth resistor, and a second comparator including a third input terminal connected to the seventh resistor, a fourth input terminal connected to the eighth resistor, and an output terminal. A ratio of the seventh resistor to a sum of the fifth resistor and the seventh resistor may be greater than a ratio of the eighth resistor to a sum of the sixth resistor and the eighth resistor.

The logic gate may include a plurality of input terminals connected to the output ends of the plurality of diagnostic circuits and an output terminal. The logic gate may apply, when values received from the output ends of the plurality of diagnostic circuits are all the first value, the first value to the processor and apply, when at least one of the values received from the output ends of the plurality of diagnostic circuits is the second value, the second value to the processor.

Each of the plurality of target elements to be diagnosed may be a switch or a fuse.

A method for diagnosing a target element performed by an electronic device may include applying a voltage to an end of each of a plurality of target elements to be diagnosed included in a plurality of diagnostic circuits and diagnosing whether the plurality of target elements to be diagnosed normally operate based on an output value of a diagnostic result output circuit generated by a logic gate based on a value received from output ends of the plurality of diagnostic circuits to which the voltage is applied.

Specific details of other embodiments are included in the detailed description and the drawings.

### Effects of the Invention

According to an example embodiment, one or more of the following effects may be expected.

According to an example embodiment of the present specification, it is possible to identify whether an element normally operates only by using a logic value generated through a logic gate without a separate direct comparison of a voltage magnification in a process of determining a normal operation of the element that operates by being connected to a power conversion device.

In addition, according to an example embodiment of the present specification, it is possible to identify an operation state of a plurality of target elements to be diagnosed, which are targets whose normal operation is to be determined, by a more lightweight method according to a change in the logic gate generating the logic value.

The effects of the present disclosure are not limited to those described above, and other effects not explicitly described may be clearly understood by those skilled in the art from the scope of the claims.

### Brief Description of Drawings

FIG. 1 is a block diagram illustrating a configuration of an electronic device according to an example embodiment.
FIG. 2 is a block diagram for describing a configuration of a diagnostic circuit according to an example embodiment.
FIG. 3 is a diagram for describing a configuration of a plurality of diagnostic circuits according to an example embodiment.
FIG. 4 is a flowchart for describing a method for diagnosing a target element according to an example embodiment.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when a component is referred to as "including" another component, the component should not be understood as excluding other components so long as there is no special conflicting description, and the component may include at least one other component.

The expression "at least one of A, B, and C" described in this specification may indicate the following meaning including: A alone; B alone; C alone; both A and B together; both A and C together; both B and C together; or all three of A, B, and C together.

In the present disclosure, a "terminal" may be implemented as a computer or a portable terminal capable of accessing a server or another terminal through a network. Here, the computer may include, for example, a laptop computer, a desktop computer, and a notebook equipped with a web browser. The portable terminal may be a wireless communication device ensuring a portability and a mobility, and include any type of handheld wireless communication device, for example, a tablet PC, a smartphone, a communication-based terminal such as international mobile telecommunication (IMT), code division multiple access (CDMA), W-code division multiple access (W-CDMA), and long term evolution (LTE).

In the following description, example embodiments of the present disclosure will be described in detail with reference to the drawings so that those skilled in the art can easily carry out the present disclosure. However, the present disclosure may be embodied in many different forms and is not limited to the embodiments described herein.

Example embodiments of the present disclosure will be described in detail with reference to the drawings hereinafter.

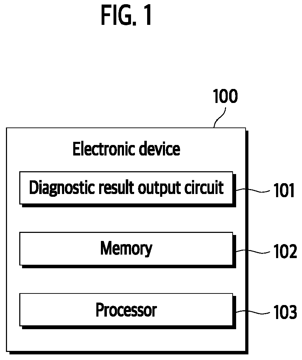

FIG. 1 is a block diagram illustrating a configuration of an electronic device according to an example embodiment.

Referring to FIG. 1, the electronic device 100 according to an example embodiment is a device for organizing and providing information. The electronic device 100 may correspond to a power conversion device that converts a form of electrical energy into another form. For example, the electronic device 100 may correspond to a rectifier that converts alternating current (AC) power into direct current (DC) power to convert household electricity or industrial power into a form usable by electronic devices. For example, the electronic device 100 may correspond to an inverter that converts DC power into AC power such that the DC power is converted into the AC power usable in households or electric power grids. For example, the electronic device 100 may correspond to a DC-DC converter that converts a voltage level of DC into another level to be usable in a battery management system and an electric vehicle. For determining whether a condition of an electrical connection between an input circuit, including a system and a battery, and an output circuit is in a normal state, the electronic device 100 may provide a function of diagnosing whether an element 200 corresponding to a protection element such as a switch or a fuse normally operates before driving a power conversion device. The electronic device 100 according to an example embodiment may determine whether the element 200 normally operates based on a value received through a diagnostic circuit included in the electronic device 100, and overall processes for performing diagnosis of a target element will be described in detail hereinafter. Here, the element 200 may correspond to a part requiring operation state diagnosis, such as a switch (field effect transistor (FET), transistor (TR), Relay) and a fuse.

The electronic device 100 according to an example embodiment may include a diagnostic result output circuit 101, a memory 102, and a processor 103. According to the electronic device 100 illustrated in FIG. 1, only components related to the example embodiment are illustrated. Accordingly, it will be understood by those skilled in the art that, in addition to the components illustrated in FIG. 1, other general-purpose components may also be included.

The diagnostic result output circuit 101 according to an example embodiment may include a plurality of diagnostic circuits and a logic gate connected to output ends of the plurality of diagnostic circuits. The plurality of diagnostic circuits may include a first diagnostic circuit to which a first target element to be diagnosed is connected. In addition, the plurality of diagnostic circuits may include a second diagnostic circuit to which a second target element to be diagnosed is connected. The plurality of diagnostic circuits of the diagnostic result output circuit 101 may include an N^{th} diagnostic circuit (N is a natural number) connected in parallel for diagnosing whether a plurality of target elements to be diagnosed normally operate. The diagnostic result output circuit 101 according to an example embodiment may include the logic gate to which output values of a comparator included in each of the plurality of diagnostic circuits are applied. Each of the plurality of diagnostic circuits included in the diagnostic result output circuit 101 according to an example embodiment may include a target element to be diagnosed, a plurality of resistors, and the comparator and transmit the output values of the comparator to the logic gate. The logic gate may apply output values to the processor 103 based on an output value of a first comparator and an output value of a second comparator of the second diagnostic circuit and enable the processor 103 to determine whether a target element to be diagnosed normally operates. Hereinafter, an example embodiment in which the first target element to be diagnosed and the second target element to be diagnosed are diagnosed through the diagnostic result output circuit 101 will be mainly described, but this is not limited to the description of the example embodiment according to the present disclosure.

The memory 102 according to an example embodiment may be hardware that stores various data processed in the electronic device 100. The memory 102 may be positioned in the processor 103 in the electronic device 100 and store data that have been processed and data that will be processed through the processor 103. In addition, the memory may store a basic programming and data structure, which may provide a function of at least one example embodiment of the present disclosure, and also store applications (programs, code modules, instructions), drivers, and the like, which may provide a function of an example embodiment of the present disclosure. The memory may include a random access memory (RAM) such as a dynamic random access memory (DRAM) and a static random access memory (SRAM), a read-only memory (ROM), an electrically erasable programmable read-only memory (EEPROM), compact disc read-only memory (CD-ROM), Blu-ray or other optical disk storages, a hard disk drive (HDD), a solid state drive (SSD), or a flash memory, but the example embodiments according to the present disclosure are not limited to the specific cases mentioned.

In an example embodiment, the processor 103 may control overall operations of the electronic device 100 and process data and signals. The processor 103 may include a microcontroller unit integrated circuit (MCU IC) of a power conversion device. The processor 103 may include at least one hardware unit. In addition, the processor 103 may be operated by one or more software modules generated by executing a program code stored in the memory 102. The processor 103 may include the memory 102. The processor 103 may execute the program code stored in the memory 102 to control overall operations of the electronic device 100 and process data and signals. That is, the processor 103 according to an example embodiment may be configured to apply a voltage to an end of each of the plurality of target elements to be diagnosed included in the plurality of diagnostic circuits and diagnose whether the plurality of target elements to be diagnosed normally operate based on an output value of the diagnostic result output circuit generated by the logic gate based on values received from the output ends of the plurality of diagnostic circuits to which the voltage is applied. Detailed description thereof will be provided hereinafter.

The electronic device 100 according to the above-mentioned example embodiments may include a processor, a storage that stores and executes program data, a permanent storage such as a disk drive, a communication port that communicates with an external device, and a user interface device such as a touch panel, a key, and a button. Methods implemented as software modules or algorithms may be stored in a computer-readable recording medium as computer-readable codes or program instructions executable by the processor. Here, the computer-readable recording medium may include a magnetic storage medium (for example, a ROM, a RAM, a floppy disk, a hard disk) and an optical reading medium (for example, a CD-ROM, a digital versatile disc (DVD)). The computer-readable recording medium may be distributed across computer systems connected through a network, and computer-readable codes may be stored and executed in a distributed manner. The medium may be readable by a computer, stored in the memory, and executed by the processor.

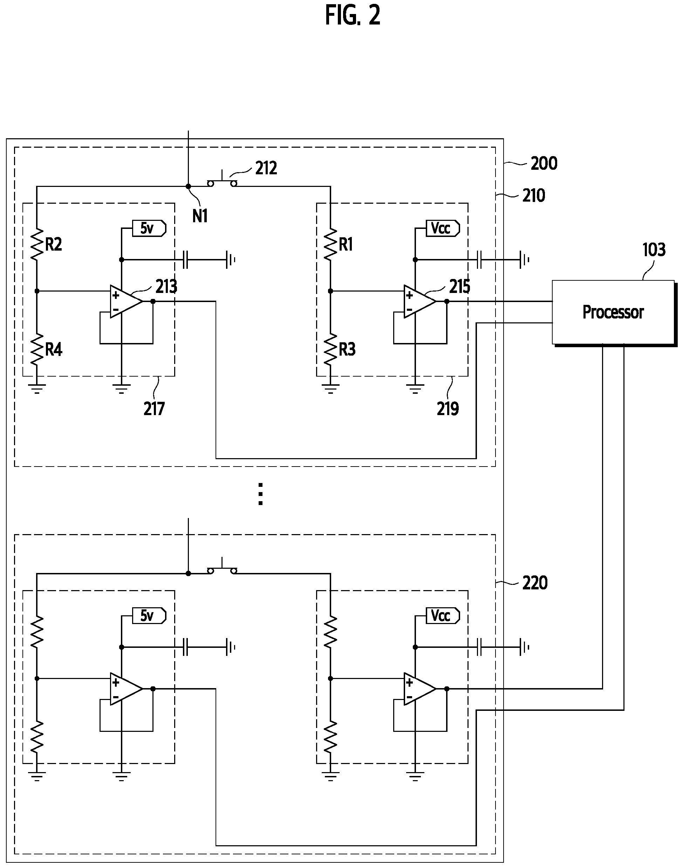

FIG. 2 is a block diagram for describing a configuration of a diagnostic circuit according to an example embodiment.

Referring to FIG. 2, a first diagnostic circuit 210 included in a diagnostic result output circuit 200 may be connected to the processor 103. The processor 103 may be configured to apply a voltage to an end N1 of a first target element to be diagnosed 212 included in the first diagnostic circuit 210. In an example embodiment, the voltage applied to the first diagnostic circuit 210 may correspond to a battery voltage of a power conversion device. The first diagnostic circuit 210 according to an example embodiment may include the first target element to be diagnosed 212. The first diagnostic circuit 210 according to an example embodiment may include a first circuit part 219 that includes a first resistor R1 connected to an end of the first target element to be diagnosed 212, a third resistor R3 connected to an end of the first resistor R1, and a first operational amplifier 215. The first operational amplifier 215 may be driven by Vcc voltage (for example, 5 V) and may correspond to a buffer structure in which an input terminal and an output terminal are connected to one another. The first diagnostic circuit 210 according to an example embodiment may include a second circuit part 217 that includes a second resistor R2 connected to the other end of the first target element to be diagnosed 212, a fourth resistor R4 connected to an end of the second resistor R2, and a second operational amplifier 213. The second operational amplifier 213 may be driven by Vcc voltage similarly to the first operational amplifier 215.

In an example embodiment, the first diagnostic circuit 210 may transmit an output value of the first operational amplifier 215 of the first circuit part 219 and an output value of the second operational amplifier 213 of the second circuit part 217 to the processor 103. The processor 103 may perform calibration to accurately compare magnitudes of voltage values received from each comparator and diagnose whether the first target element to be diagnosed 212 normally operates. For example, the processor 103 may calibrate a voltage value received from the first operational amplifier 215 and calibrate a value received from the second operational amplifier 215 to compare magnitudes of each voltage value. For example, when the first target element to be diagnosed 212 normally operates, the output value of the first operational amplifier 215 and the output value of the second operational amplifier 213 may be transmitted to the processor 103 according to magnitudes and ratio relationships of the first resistor R1 to the fourth resistor R4. The processor 103 may compare a condition predetermined according to the magnitudes and ratio relationships of the first resistor R1 to the fourth resistor R4 with the output value of the first operational amplifier 215 and the output value of the second operational amplifier 213 to determine that the first target element to be diagnosed 212 normally operates. For example, when the first target element to be diagnosed 212 does not normally operate (for example, when the first target element to be diagnosed 212 is operated in a closed state due to internal disconnection of the first target element to be diagnosed 212, but actually the first target element to be diagnosed 212 is operated in an open state), since a voltage is not applied to the first resistor R1, the processor 103 may receive an output value of the first operational amplifier 215 as 0 V and thus determine that the first target element to be diagnosed 212 does not normally operate.

Likewise, in the case of the second diagnostic circuit 220 that is connected to the first diagnostic circuit 210 in parallel and includes a target element to be diagnosed other than the first target element to be diagnosed 212, the second diagnostic circuit 220 may apply at least two output values to the processor 103 through at least two circuit parts, and the processor 103 may determine, similarly to the first diagnostic circuit 210, whether the target element to be diagnosed normally operates.

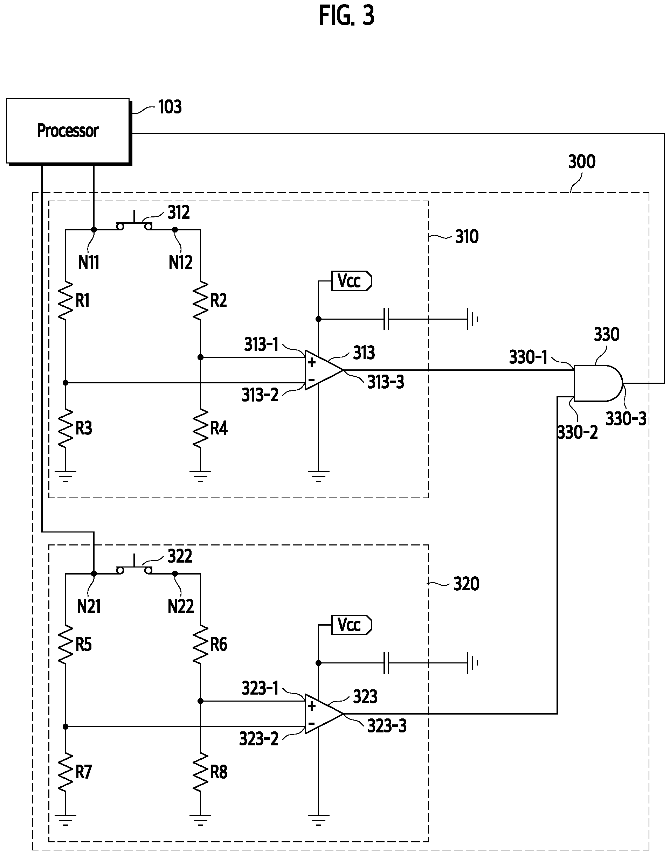

FIG. 3 is a diagram for describing a configuration of a plurality of diagnostic circuits according to an example embodiment.

Referring to FIG. 3, a diagnostic result output circuit 300 according to an example embodiment may include a plurality of diagnostic circuits (for example, a first diagnostic circuit 310 and a second diagnostic circuit 320) and a logic gate (for example, a logic gate 330) connected to output ends of the plurality of diagnostic circuits.

For example, a first target element to be diagnosed 312 may be connected to the first diagnostic circuit 310. The first diagnostic circuit 310 may include a first resistor R1 connected to a first end N11 of the first target element to be diagnosed 312. A battery voltage may be applied to the first end N11 of the first target element to be diagnosed 312. The first diagnostic circuit 310 may include a second resistor R2 connected to a second end N12 of the first target element to be diagnosed 312, a third resistor R3 connected to the first resistor R1, and a fourth resistor R4 connected to the second resistor R2.

The first diagnostic circuit 310 may include a first comparator 313 that includes a first input terminal 313-1 connected to the fourth resistor R4, a second input terminal 313-2 connected to the third resistor R3, and an output terminal 313-3. In an example embodiment, the first comparator 313 may be configured based on an operational amplifier driven by Vcc voltage (for example, 5 V) and may be configured to, as a signal voltage to be compared is input into an inverting terminal and a reference voltage is input into a non-inverting terminal, output different logic values based on a voltage difference of the signal voltage and the reference voltage. Description of a comparator in the present disclosure may be equally applied hereinafter.

In an example embodiment, a ratio of the fourth resistor R4 to a sum of the second resistor R2 and the fourth resistor R4 may be greater than a ratio of the third resistor R3 to a sum of the first resistor R1 and the third resistor R3. For example, when the first target element to be diagnosed 312 normally operates, a voltage applied to the first end N1 of the first target element to be diagnosed 312 in a state in which the first target element to be diagnosed 312 is closed may also be applied to the second end N1 of the target element to be diagnosed 312. In this case, since the ratio of the fourth resistor R4 to the sum of the second resistor R2 and the fourth resistor R4 is greater than the ratio of the third resistor R3 to the sum of the first resistor R1 and the third resistor R3, a voltage input to the first comparator 313 through the first input terminal 313-1 connected to the fourth resistor R4 may be greater than a voltage input to the first comparator 313 through the second input terminal 313-2 connected to the third resistor R3. The first comparator 313 according to an example embodiment may output a first value (for example, "1") to the output terminal 313-3 when a voltage applied to the first input terminal 313-1 is greater than a voltage applied to the second input terminal 313-2. The first comparator 313 according to an example embodiment may output a second value (for example, "0") to the output terminal 313-3 when the voltage applied to the first input terminal 313-1 is less than the voltage applied to the second input terminal 313-2. In this case, each of the first value and the second value output by the first comparator 313 may correspond to a logic value. In other words, when the first target element to be diagnosed 312 normally operates, since the voltage applied to the first input terminal 313-1 becomes greater than the voltage applied to the second input terminal 313-2, the first value may be output from the output terminal 313-3 of the first comparator 313.

For example, when the target element to be diagnosed 312 does not normally operate (when the first target element to be diagnosed 212 is operated in a closed state due to an internal disconnection of the first target element to be diagnosed 212, but actually the first target element to be diagnosed 212 is operated in an open state), a voltage applied to the first end N11 of the first target element to be diagnosed 312 in a state in which the first target element to be diagnosed 312 is closed may not be applied to the second end N12 of the first target element to be diagnosed 312. In this case, the voltage input to the first comparator 313 through the first input terminal 313-1 connected to the fourth resistor R4 may be less than the voltage input to the first comparator 313 through the second input terminal 313-2 connected to the third resistor R3. The second value may be output from the output terminal 313-3 of the first comparator 313 according to an example embodiment.

A second target element to be diagnosed 322 may be connected to the second diagnostic circuit 320 according to an example embodiment. The second diagnostic circuit 320 may include a fifth resistor R5 connected to a first end N21 of the second target element to be diagnosed 322. A battery voltage may be applied to the first end N21 of the second target element to be diagnosed 322. The second diagnostic circuit 320 may include a sixth resistor R6 connected to a second end N22 of the second target element to be diagnosed 322, a seventh resistor R7 connected to the fifth resistor R5, and an eighth resistor R8 connected to the sixth resistor R6. The second diagnostic circuit 320 may include a second comparator 323 that includes a first input terminal 323-1 connected to the eighth resistor R8, a second input terminal 323-2 connected to the seventh resistor R7, and an output terminal 323-3. In an example embodiment, a ratio of the eighth resistor R8 to a sum of the sixth resistor R6 and the eighth resistor R8 may be greater than a ratio of the seventh resistor R7 to a sum of the fifth resistor R5 and the seventh resistor R7.

For example, when the second target element to be diagnosed 322 normally operates, a voltage applied to the first end N21 of the target element to be diagnosed 322 may also be applied to the second end N22 of the target element to be diagnosed 322. In this case, since the ratio of the eighth resistor R8 to the sum of the sixth resistor R6 and the eighth resistor R8 is greater than the ratio of the seventh resistor R7 to the sum of the fifth resistor R5 and the seventh resistor R7, a voltage input to the second comparator 323 through the first input terminal 323-1 connected to the eighth resistor R8 may be greater than a voltage input to the second comparator 323 through the second input terminal 323-2 connected to the seventh resistor R7. The second comparator 323 according to an example embodiment may output a first value (for example, "1") to the output terminal 323-3 when a voltage applied to the first input terminal 323-1 is greater than a voltage applied to the second input terminal 323-2 and may output a second value (for example, "0") to the second output terminal 323-3 when the voltage applied to the first input terminal 323-1 is less than the voltage applied to the second input terminal 323-2. In an example embodiment, when the second target element to be diagnosed 322 normally operates, since the voltage applied to the first input terminal 323-1 becomes greater than the voltage applied to the second input terminal 323-2, the second value may be output from the output terminal 323-3 of the second comparator 323.

For example, when the second target element to be diagnosed 322 does not normally operate, the voltage applied to the first end N21 of the second target element to be diagnosed 322 may not be applied to the second end N22 of the second target element to be diagnosed 322. In this case, the voltage input to the second comparator 323 through the first input terminal 323-1 connected to the eighth resistor R8 may be less than the voltage input to the second comparator 323 through the second input terminal 323-2 connected to the seventh resistor R7. In an example embodiment, when the second target element to be diagnosed 322 does not normally operate, since the voltage applied to the first input terminal 323-1 becomes less than the voltage applied to the second input terminal 323-2, the second value may be output from the output terminal 323-3 of the second comparator 323.

The diagnostic result output circuit 101 according to an example embodiment may further include a logic gate 330 including a plurality of input terminals (for example, the first input terminal 330-1 and the second input terminal 330-2) connected to output ends (for example, the output terminal 313-3 of the first comparator 313 and the output terminal 323-3 of the second comparator 323) of a plurality of diagnostic circuits (for example, the first diagnostic circuit 310 and the second diagnostic circuit 320) and an output terminal (for example, the output terminal 330-3). The logic gate 330 may correspond to an AND gate that outputs the first value only when two or more input signals are all the first value. The logic gate 330 may apply the first value to the processor 103 through the output terminal 330-1 when a value received from the output terminal 313-3 of the first comparator 313 is the first value and a value received from the output terminal 323-3 of the second comparator 323 is the first value. The logic gate 330 may apply the second value to the processor 103 when at least one of values received from the output ends of the plurality of diagnostic circuits is the second value. For example, when at least one of the value received from the output terminal 313-3 of the first comparator 313 and the value received from the output terminal 323-3 of the second comparator 323 is the second value, the logic gate 330 may apply the second value to the processor 103 through the output terminal 330-1.

When the first value is applied through the output terminal 330-1 of the logic gate 330, the processor 103 according to an example embodiment may determine that all of the first target element to be diagnosed 312 and the second target element to be diagnosed 322 normally operate. When the second value is applied through the output terminal 330-1 of the logic gate 330, the processor 103 according to an example embodiment may determine that at least one of the first target element to be diagnosed 312 and the second target element to be diagnosed 322 is in a defective state, not normally operating. In FIG. 3, it is merely illustrated that the plurality of target elements to be diagnosed correspond to the first target element to be diagnosed 312 and the second target element to be diagnosed 322 and that the plurality of diagnostic circuits correspond to the first diagnostic circuit 310 and the second diagnostic circuit 320, but example embodiments according to the present disclosure are not limited thereto. The processor 103 according to an example embodiment may perform, for the plurality of target elements to be diagnosed included in the plurality of diagnostic circuits connected in parallel to the logic gate 330 having the plurality of input terminals, diagnosis of elements based on an output value of the logic gate 330 having the plurality of input terminals.

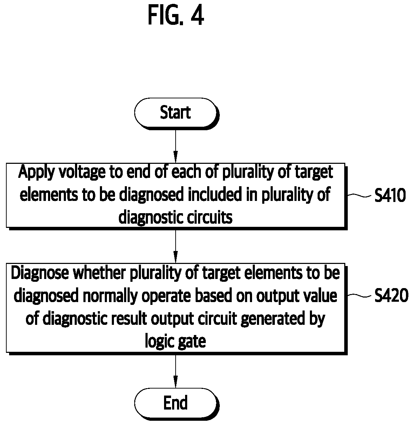

FIG. 4 is a flowchart for describing a method for diagnosing a target element according to an example embodiment.

Referring to FIG. 4, in operation S410, the electronic device 100 according to an example embodiment may apply a voltage to an end of each of a plurality of target elements to be diagnosed included in a plurality of diagnostic circuits. For example, in a state in which the plurality of target elements to be diagnosed are all closed, the electronic device 100 according to an example embodiment may apply a voltage to an end of each of the target elements to be diagnosed of the plurality of diagnostic circuits included in a diagnostic result output circuit. For example, the voltage applied by the electronic device 100 to an end of each of the plurality of target elements to be diagnosed may correspond to a battery voltage for driving the electronic device 100.

In operation S420, the electronic device 100 according to an example embodiment may diagnose whether the plurality of target elements to be diagnosed normally operate based on an output value of the diagnostic result output circuit, which is generated by a logic gate. In an example embodiment, the output value of the diagnostic result output circuit, which is generated by the logic gate, may correspond to a logic value generated based on an output value of a comparator of each diagnostic circuit included in the diagnostic result output circuit. When a first value is received through an output end of the diagnostic result output circuit, the electronic device 100 according to an example embodiment may determine that the plurality of target elements to be diagnosed normally operate. When a second value is received through the output end of the diagnostic result output circuit, the electronic device 100 according to an example embodiment may determine that at least one of the plurality of target elements to be diagnosed abnormally operates. When the first value is received from the diagnostic result output circuit, the electronic device 100 according to an example embodiment may provide a notification that all of the plurality of target elements to be diagnosed normally operate. When the second value is received from the diagnostic result output circuit, the electronic device 100 may provide a notification that at least one of the plurality of target elements to be diagnosed abnormally operates.

Meanwhile, disclosed are exemplary embodiments of the present disclosure in the present specification and drawings, it should be understood that specific terms used herein are merely for the purpose of easily describing the technical content of the present disclosure and facilitating understanding of the present disclosure, and are not intended to limit the scope of the present disclosure. It will be apparent to those skilled in the art that, in addition to the embodiments disclosed herein, various modifications based on the technical spirit of the present disclosure may also be implemented.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that components may be executed by software programming or software components, the present example embodiments may be implemented by programming or scripting languages such as C, C++, Java, and assembler language, and Python including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing. The terms "mechanism", "component", "means", and "configuration" may be widely used and are not limited to mechanical and physical elements. These terms may include meaning of a series of routines of software in association with the processor.

The above-described example embodiments are merely examples, and other example embodiments may be implemented within the scope of the following claims.

## Claims

1. An electronic device comprising:
a diagnostic result output circuit including a plurality of diagnostic circuits and a logic gate connected to output ends of the plurality of diagnostic circuits;
a memory configured to store an instruction; and
a processor connected to the memory,
wherein the processor is configured to apply a voltage to an end of each of a plurality of target elements to be diagnosed included in the plurality of diagnostic circuits and diagnose whether the plurality of target elements to be diagnosed normally operate based on an output value of the diagnostic result output circuit generated by the logic gate based on values received from the output ends of the plurality of diagnostic circuits to which the voltage is applied.

2. The electronic device of claim 1, wherein the processor is configured to determine, when a first value is received through an output end of the diagnostic result output circuit, that the plurality of target elements to be diagnosed normally operate and determine, when a second value is received through the output end of the diagnostic result output circuit, that at least one of the plurality of target elements to be diagnosed abnormally operates.

3. The electronic device of claim 1, wherein the plurality of diagnostic circuits include a first diagnostic circuit,
wherein the first diagnostic circuit comprises:
a first resistor connected to a first end of a first target element to be diagnosed;
a second resistor connected to a second end of the first target element to be diagnosed;
a third resistor connected to the first resistor;
a fourth resistor connected to the second resistor; and
a first comparator including a first input terminal connected to the third resistor, a second input terminal connected to the fourth resistor, and an output terminal.

4. The electronic device of claim 3, wherein a ratio of the third resistor to a sum of the first resistor and the third resistor is greater than a ratio of the fourth resistor to a sum of the second resistor and the fourth resistor.

5. The electronic device of claim 3, wherein the first comparator is configured to output, when a voltage applied to the first input terminal is greater than a voltage applied to the second input terminal, a first value to the logic gate through the output terminal and output, when the voltage applied to the first input terminal is less than a voltage applied to the second input terminal, a second value to the logic gate through the output terminal.

6. The electronic device of claim 1, wherein the plurality of diagnostic circuits include a second diagnostic circuit,
wherein the second diagnostic circuit comprises:
a fifth resistor connected to a first end of a second target element to be diagnosed;
a sixth resistor connected to a second end of the second target element to be diagnosed;
a seventh resistor connected to the fifth resistor;
an eighth resistor connected to the sixth resistor; and
a second comparator including a third input terminal connected to the seventh resistor, a fourth input terminal connected to the eighth resistor, and an output terminal, and
wherein a ratio of the seventh resistor to a sum of the fifth resistor and the seventh resistor is greater than a ratio of the eighth resistor to a sum of the sixth resistor and the eighth resistor.

7. The electronic device of claim 1, wherein the logic gate includes a plurality of input terminals connected to the output ends of the plurality of diagnostic circuits and an output terminal, and
wherein the logic gate is configured to apply, when values received from the output ends of the plurality of diagnostic circuits are all first value, the first value to the processor and apply, when at least one of the values received from the output ends of the plurality of diagnostic circuits is second value, the second value to the processor.

8. The electronic device of claim 1, wherein each of the plurality of target elements to be diagnosed is a switch or a fuse.

9. A method for diagnosing a target element performed by an electronic device, the method comprising:
applying a voltage to an end of each of a plurality of target elements to be diagnosed included in a plurality of diagnostic circuits; and
diagnosing whether the plurality of target elements to be diagnosed normally operate based on an output value of a diagnostic result output circuit generated by a logic gate based on values received from output ends of the plurality of diagnostic circuits to which the voltage is applied.

10. A non-transitory computer-readable recording medium recording a program for executing the method for diagnosing a target element of claim 9 in an electronic device.
